# EUROPEAN PATENT SPECIFICATION

(11) **EP 3 368 240 B1**
(45) Date of publication and mention of the grant of the patent: **14.04.2021**
(21) Application number: 16860703.4
(22) Date of filing: 26.10.2016
(51) Int. Cl.: B23K 1/00, B23K 1/19, B23K 20/02, B23K 20/10, B23K 20/233, C25D 3/04, C25D 3/48, C25D 5/48, C25D 5/50, C25D 5/56, C25D 7/00, C23C 18/18, C23C 18/20, C23C 18/16, C23C 18/32, C23C 18/42, C23C 14/18, C23C 14/20, B23K 101/34, B23K 103/08, B23K 103/16, B23K 103/00

(54) **METHOD OF MANUFACTURING**
HERSTELLUNGSVERFAHREN
PROCÉDÉ DE FABRICATION

(30) Priority: 27.10.2015 US 201562246909 P; 23.03.2016 US 201662312012 P
(43) Date of publication of application: 05.09.2018
(73) Proprietor: Hutchinson Technology Incorporated, Hutchinson, Minnesota 55350-9784 (US)
(72) Inventor: DAVIS, Michael W., Rockford, Minnesota 55373 (US); RIEMER, Douglas P., Waconia, Minnesota 55387 (US); OLSEN, Clark T., Dassel, Minnesota 55325 (US); LAGERGREN, Steven R., Litchfield, Minnesota 55355 (US); PESAVENTO, Paul V., Hutchinson, Minnesota 55350 (US)
(74) Representative: Anderson, Oliver Ben
(86) International application number: PCT/US2016/058902
(87) International publication number: WO 2017/075076

(56) References cited:
- EP-A1- 0 124 140
- WO-A-84/04762
- DE-A1- 19 803 392
- US-A- 4 837 068
- US-A1- 2010 072 643
- US-A1- 2014 298 875
- US-B1- 6 870 708

## Description

This disclosure relates generally to techniques for joining polymeric, ceramic, or ceramic-polymer composite components to another component, and more particularly to a method of manufacture according to the preamble of claim 1 (see for example WO 84/04762 A1).

### BACKGROUND

In overmolding to create structural attachment between a polymeric, ceramic, or ceramic-polymer composite component and underlying component(s) within an assembly, it may be difficult to obtain an adequate bond. This is exacerbated when the overall assembly size is preferably as small as possible, since the overmold requires adding to the volume of the assembly. Overmolded component surfaces may have limited or no adhesion to the surfaces of the underlying component. This lack of adhesion between mating surfaces of an assembly including an overmolded component may limit the strength of the assembly compared to alternatives in which adjacent surfaces of components within an assembly are adhered to each other.

The purpose of the technology described in WO 84/04762 A1 is to provide light and less costly components manufactured of a plated high temperature and high strength plastic material which are capable of withstanding a sustained high temperature soldering process such as hot oil dip and vapor phase and which are usable in a wide variety of applications including the electronics area.

EP 0 124 140 A1 describes a method of manufacturing an optically readable information disc which comprises a disc-shaped substrate manufactured from a synthetic resin or bearing a coating layer of a synthetic resin and which comprises on at least one side an optically readable structure of information areas situated alternately at a higher level and at a lower level.

The technology described in DE 198 03 392 A1 is based on the object of specifying a method for producing a solder connection and a solder connection for a component, in particular for the connection of metallized plastic parts, in which additional adhesives and the use of higher temperatures for producing the connection can be dispensed with, and the use thereof such a solder connection.

A method of manufacture according to the present invention is defined in claim 1.

Further embodiments of the present invention are defined in the dependent claims.

### DETAILED DESCRIPTION

Manufacture techniques disclosed herein facilitate attachment surfaces on a non-metallic component, such as a polymeric (e.g., plastic), ceramic, or ceramic-polymer composite component for attaching the non-metallic component to a metal component, or another non-metallic component. As one example, surfaces to be joined are metallized to provide a 'tie' layer so that alternative bonding methods can be used. For polymeric and ceramic components, the metallized layers can be created with sputtering, such as sputtering with chromium and or copper. For metal components, sputtering or plating, such as nickel plating, can be used if needed to provide a metallized 'tie' layer suitable for joining. The metallized 'tie' layers can be joined with a variety of methods, including, for example, soldering, brazing, adhesive bonding (using an adhesive designed for metal to metal bonding), metal fusion bonding, such as gold fusion bonding, and other metal to metal joining techniques. The techniques disclosed herein may be particularly useful for joining plastic to plastic, ceramic to ceramic, ceramic to metal, ceramic to plastic and/or plastic to metal components for products exposed to harsh environments, such as medical applications.

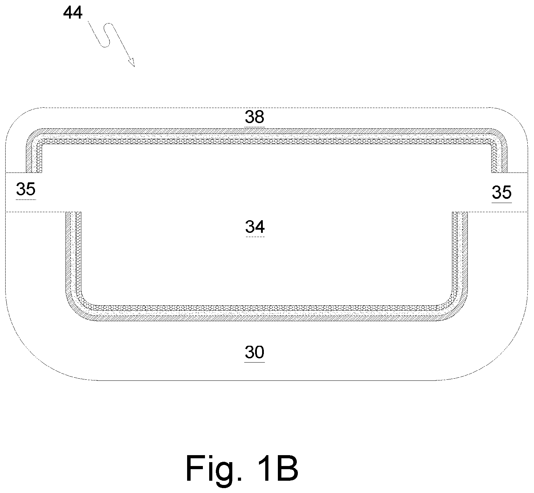

When joining surfaces of components with at least one polymeric or ceramic surface, such as non-metallic spacer 34 of assembly 44 (FIG. 1B), bonding directly to the polymeric or ceramic surface may result in poor adhesion. As disclosed herein, first applying a metallized tie layer to the polymeric or ceramic surface provides a different functional surface for an adhesive to bond to. In the case of bonding two polymeric or ceramic components together, both components are, according to the present invention, selectively sputtered with a metallized tie layer so that a metal-to-metal adhesive may be applied to join the surfaces. Such metal-to-metal adhesive may provide good bonding to the metallized tie layers and provide improved adhesion as compared to conventional techniques for polymer to polymer, ceramic to ceramic, ceramic to plastic, ceramic to metal and/or plastic to metal bonding.

These techniques may facilitate attaching a formed (planer or non-planar) metal component to a non-metallic component, such as a support structure, spacer or stand-off, although it could also be used to bond two non-metallic components. The non-metallic component can alternatively be formed using other known methods for example, stamping, laser cutting, machining, and extruding.

In the example of two non-metallic components, the described surface preparation techniques is applied, according to the present invention, to both of the non-metallic surfaces being attached and bonded. For plastic to plastic, ceramic to ceramic or ceramic to plastic surface joining, metalized surfaces are made, according to the present invention, on both non-metallic components to act as a different surface onto which the bond can occur. Bonding may occur by solder, brazing, Au bonding, adhesives, or other metal to metal bonding techniques.

Certain ceramics, ceramic-polymer composites and plastic resins in the polyamide family such as Zytel, Akromid, Amodel, and similar are difficult to bond to metals including bonding with adhesives. Difficulties in such bonding may occur when the surface is non-planer or has 3D curved surfaces that mate. The techniques disclosed herein may be particularly useful for bonding such ceramics, ceramic-polymer composites and plastic resins to metal, ceramic or polymeric components.

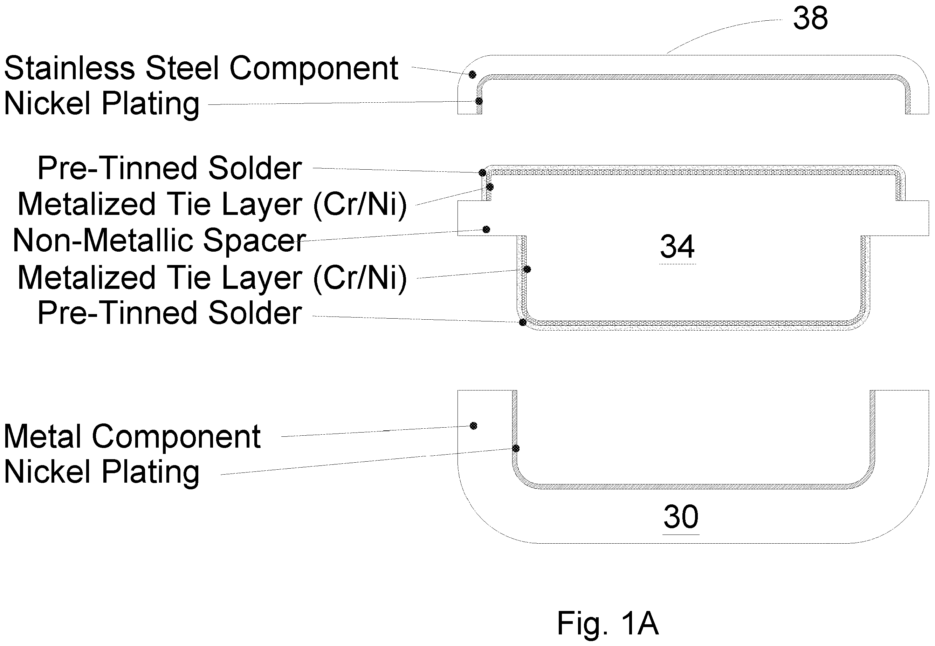

FIGS. 1A - 1B illustrate components of an assembly 44. FIGS. 1A - 1B illustrate an assembly technique utilizing solder as the attachment method between the tie layers. In particular, FIG. 1A illustrates an exploded view of the components of assembly 44, whereas

FIG. 1B illustrates a cross-sectional view of the attached components of assembly 44.

Assembly 44 includes metal component 30, non-metallic spacer 34 and stainless steel component 38. As shown in FIG. 1B, metal component 30 and stainless steel component 38 include optional nickel plating layers on surface to be joined with non-metallic spacer 34. Likewise, non-metallic spacer 34 includes metalized tie layer, such as a chromium, copper, and/or nickel layer, as well as a solder layer that can be pre-tinned or applied using other known methods, on the surfaces to be joined with metal component 30 and stainless steel component 38. Such solder may be a solder suitable for use on medical devices, such as Indalloy 121 (or similar). In alternative examples, in which adhesive joining the metallized surfaces is chosen in place of solder, then the solder layer is not needed. Stainless steel component 38 may include a plating layer, such as a nickel plating layer.

Prior to metal-to-metal bonding techniques to bond metal component 30, non-metallic spacer 34 and stainless steel component 38 together, the components should be properly aligned as desired for the final assembly. For solder attach bonding, the components may be stacked and aligned and baked to allow the pre-tinned low temp solder to reflow and wet to the metallized portions of the mating pieces. Generally, the solder should wet only to the metallized regions.

In glue attach bonding, (metallized to metallized), adhesive may be applied before stacking and aligning the components. The metallized faces provide an alternative to bonding directly to non-metallic spacer 34 and may provide stronger adhesion that directly applying an adhesive to non-metallic spacer 34.

As shown in FIG. 1B, metal component 30, non-metallic spacer 34 and stainless steel component 38 may be joined by way metal-to-metal bonding techniques, such as solder or other techniques. In this manner, an overmold layer is not needed. The interface surfaces for a strong mechanical attachment provided by the metalized tie layer on non-metallic spacer 34 allows non-metallic spacer 34 to be joined using metal joining techniques to other components, such as metal component 30 and stainless steel component 38. These techniques eliminate the need for an overmold.

Assembly 44 provides sealing between metal component 30, non-metallic spacer 34 and stainless steel component 38. For this reason, in a bending type loading applied to assembly 44, the three layers, i.e., metal component 30, non-metallic spacer 34 and stainless steel component 38, reinforce each other to provide additional bending strength than with what may be achieved with conventional overmolding.

In some particular examples, assembly 44 may represent components within a medical instrument. In such examples, it may be important to electrically and/or thermally isolate stainless steel component 38 from metal component 30. In some such examples, the thickness of stainless steel component 38 may be about 0.254 mm (0.010 inches). In the same or different examples, the thickness of metal component 30 may be about 0.635 mm (0.025 inches). Attachment surfaces of metal component 30 and stainless steel component 38 may be optionally nickel plated, chrome plated or plated with other materials to provide the proper tie layer interface. In addition, adjacent surfaces of non-metallic spacer 34 are metalized, according to the present invention, with a tie layer to facilitate bonding to metal component 30 and stainless steel component 38 using metal-to-metal joining techniques. Such metalized tie layers are optionally patterned. In some examples, non-metallic spacer 34 may be a polymeric component, such as an injection molded fiber filled component, such as glass fiber or carbon fiber component, a ceramic component, or a blend of polymer and ceramic materials forming a composite component.

In a variation of assembly according to the present invention, a high strength non-metallic is added instead of metal component 30 in order to provide structural strength to the assembly.

In a further variation of assembly 44 according to the present invention, stainless steel component 38 is replaced with an electroplated component on a high strength non-metallic component layer.

Following the formation of a metalized tie layer on the non-metallic component, the surface of the non-metallic component is positioned to mate with a metallic surface of a second component. Then the metallized tie layer on the non-metallic component is joined with the mated metallic surface of the second component using metal to metal joining techniques.

The second component is, according to the present invention, a metal component or a non-metallic component with a second metallized tie layer on the second component. In different examples, metallized tie layers may be used for joining plastic to plastic, ceramic to ceramic, ceramic to metal, ceramic to plastic and/or plastic to metal components for products exposed to harsh environments, such as medical applications.

In accordance with the techniques disclosed herein, possible methods of metal-to-metal attachment of one or more non-metallic components include, fusion of metal (welding), brazing, soldering, adhesive bonding, fusion of plated metals (e.g., via ultrasonics or resistance), or other metal-to-metal bonding techniques as discussed in further detail below.

As the properties of certain base materials, such as metallic components and metallic components may be affected at temperatures required for particular bonding techniques, metal-to-metal bonding techniques that do not require temperatures adverse to the base materials. Generally speaking, bonding techniques rely on materially-compatible (wettable and having an ability to form a strong bond after wetting and cooling/solidification), pre-prepared substrate and bonding part surfaces that can readily adhere / bond to the molten metal bonding material.

In addition to the techniques listed above, low temperature melting nanoparticle material bonding techniques may be useful in some examples for joining plastic to plastic, ceramic to ceramic, ceramic to metal, ceramic to plastic and/or plastic to metal components. With low temperature melting nanoparticle material bonding a "nanoparticle" solder that achieves lower processing temperatures by using small particle sizes to fully melt the solder at temperatures the base material of component can handle.

As another example, low temperature and pressure sintering bonding techniques may be useful in some examples for joining plastic to plastic, ceramic to ceramic, ceramic to metal, ceramic to plastic and/or plastic to metal components. With low temperature and pressure sintering bonding sintering mostly relies on partially melting a bonding material (such as softening/melting the surface of the particles to be sintered) and then applying pressure to form the high surface area strong bond with the components. Such techniques may use a low-temperature "nanoparticle" solder or other sintering materials.

As other examples, melting or reactive photonic curing or sintering bonding may be useful in some examples for joining plastic to plastic, ceramic to ceramic, ceramic to metal, ceramic to plastic and/or plastic to metal components. With melting or reactive photonic curing or sintering bonding a "flashlamp melted" material may allow for maintaining low temperatures through ultra-fast heating and melting of the bonding material. The bonding material may absorb the flashlamp energy and simply melt or the bonding material may starts an exothermic, self-sustaining reaction at the surface which may propagate across and through the film such that the film which melts itself and wets and heats the surface of components to form a bond.

As other examples, low temperature and pressure reactive soldering / brazing material bonding may be useful in some examples for joining plastic to plastic, ceramic to ceramic, ceramic to metal, ceramic to plastic and/or plastic to metal components. With low temperature and pressure reactive soldering / brazing material bonding a molten compound formation, typically a eutectic compound, may be located between the metal bonding material and the substrate and component. Such techniques are distinct than those in which rely upon a melting of only the bonding material which then wets to the components. The molten material for low temperature and pressure reactive soldering / brazing material bonding can be formed through the application of heat and pressure to get interdiffusion and start the eutectic compound formation, which then melts at the current temp. Alternatively or additionally, the molten material for low temperature and pressure reactive soldering / brazing material bonding can be formed by using multiple-component (mixtures of particles or multilayer films) bonding materials such that they melt and intermix due to an ignition event (such as an electric arc or laser heating at one tiny spot), then, due to high energy of mixing and self-propagating reaction, the entire bonding material melts and gives off enormous amounts of heat, which causes strong bond formation to the substrate and bonding part while maintaining low average/equilibrium temperature and minimizing the thermal effect on substrates.

### Examples, not covered by the present invention

Variations of processing options for joining a non-metallic surface to a metal surface, such as a joining a non-metallic surface non-planar (3D) metal surface, as shown in FIG. 1B, are described below. These examples are merely representative of the techniques disclosed herein and other techniques may be used within the spirit of this disclosure.
Example A: A non-metallic component, such as a plastic, ceramic or plastic ceramic composite 3D component, is modified with an oxygen containing plasma. A surface of the non-metallic component is then sputtered with Cr to form a tie layer to a subsequent solderable metal. The tie layer is from 50 angstrom to 500 angstroms thick. The tie layer is preferably 75 to 150 angstroms thick. The sputtered subsequent solderable metal is chosen from Cu, Ni, Au, Pt, Pd, etc., such as Ni, Pt, Pd. The thickness of the solderable metal may be greater than 500 angstroms and less than 50000 angstroms, such as greater than 1000 angstroms and less than 5000 angstroms.
Example B: In this example, the techniques of Example A are repeated with the addition of compression bonding using gold as the bonding material and chrome as the tie layer.
Example C: In this example, the techniques of Example A are repeated with mismatched metals such as nickel on one surface, Pd on another, or Au on one and nickel on the other, etc.
Example D: In this example, the techniques of Example A are repeated where the non-metallic component is difficult to bond by adhesives such as polyamides, polytetraflourides, polydiflourides, etc.
Example E: In this example, bonding two non-metallic components are bonded together. Mating surfaces of both components are selectively sputtered with a metallized tie layer so that a metal-to-metal joining techniques, such as a metal-to-metal adhesive may be applied to join the surfaces. Such metal-to-metal adhesive be may provide good bonding to the metallized tie layers and provide improved adhesion as compared to conventional techniques for plastic to plastic, ceramic to ceramic or ceramic to plastic bonding.

Although the disclosed techniques have been described with reference to various examples, those skilled in the art will recognize that changes can be made in form and detail without departing from the scope of the present invention as defined in the appended claims.

## Claims

1. A method of manufacture comprising:
forming a first metallized tie layer on a first surface of a non-metallic spacer component (34), the non-metallic spacer component (34) configured to join a first component (30) and a second component (38);
and being **characterised by** the following steps:
forming a second metallized tie layer on a second surface of the non-metallic spacer component (34) opposite the first surface, wherein the first metallized tie layer is separate from the second metallized tie layer;
positioning the second surface of the non-metallic spacer component (34) to mate with a metallic surface of the first component (30), the first component (30) is either a metal or a non-metallic component with a metallised tie layer on the first component (30), and joining the second metallized tie layer with the mated metallic surface of the first component (30); and
positioning the first surface of the non-metallic spacer component (34) to mate with a metallic surface of a second component (38), the second component (38) is either a metal component (38) or a non-metallic component (38) with a metallised tie layer on the second component (38), and joining the first metallized tie layer with the mated metallic surface of the second component (38), wherein the joining of the non-metallic spacer component (34) with the first component (30) and with the second component (38) uses metal to metal joining techniques.

2. The method of claim 1, wherein the non-metallic spacer component (34) is one of a group consisting of:
a polymeric component;
a ceramic component;
a ceramic-polymer composite component; and
a resin plastic injection molded component.

3. The method of claim 1 or claim 2, wherein joining the first metallized tie layer with the mated metallic surface of the second component (38) and joining the second metallized tie layer with the mated metallic surface of the first component (30) uses techniques including compression fusion welding.

4. The method of any of claims 1-3, wherein forming a metallized tie layer includes at least one of:
electroplating;
electroless plating;
vacuum deposition;
sputtering of a metal including one or more of Ti, Cr, Ta, Ru, NiChrome and NiV; and
vapor deposition.

5. The method of any of claims 1-4, further comprising modifying the surface of the non-metallic spacer component (34) by at least one of:
an ion source containing oxygen, or argon or both prior to forming the metallized tie layer on the surface of the non-metallic spacer component (34); and
an plasma source containing oxygen, or argon or both prior to forming the metallized tie layer on the surface of the non-metallic spacer component (34).

6. The method of any of claims 1-5, wherein the surface of the non-metallic spacer component (34) is a 3D surface.

7. The method of claim 6, further comprising bonding or adhering a gold layer over the metallized tie layer prior to joining the first metallized tie layer with the mated metallic surface of the second component.

8. The method of claim 6 or claim 7, wherein the non-metallic spacer component (34) is a resin plastic injection molded component.

9. The method of any of claims 1 - 8, wherein joining the first metallized tie layer with the mated metallic surface of the second component (38) and joining the second metallized tie layer with the mated metallic surface of the first component (30) uses techniques including at least one of:
reflow of solder attached to both surfaces, and
reflow of solder attached to the metallized tie layer.

10. The method of claim 9, wherein the solder is bonded to the non-metallic spacer component (34) with a solderable metal including one or more of Cu, Au, Ag, Ni, Ru, Cd, Sn, Rd, Brass and Pb.

11. The method of any of claims 9 - 10, wherein the solderable metal is cohesively bonded to the non-metallic spacer component (34) by the metallized tie layer.

12. The method of any of claims 9 - 11, wherein the solderable metal forms an intermetallic without fully dissolving into the solder.

13. The method of any of claims 1 - 12, wherein the second component (38) is a metal component.

14. The method of any of claims 1 - 12, wherein the second component (38) is a second non-metallic component, wherein the mated metallic surface of the second component (38) includes a second metallized tie layer.

15. The method of claim 14, wherein the second non-metallic component (38) is one of a group consisting of:
a polymeric component;
a ceramic component;
a ceramic-polymer composite component; and
a resin plastic injection molded component.

## Patentansprüche

1. Herstellungsverfahren, umfassend:
Bilden einer ersten metallisierten Bindungsschicht auf einer ersten Oberfläche einer nichtmetallischen Abstandshalterkomponente (34), wobei die nichtmetallische Abstandshalterkomponente (34) konfiguriert ist, um eine erste Komponente (30) und eine zweite Komponente (38) zu verbinden; und **gekennzeichnet durch** die folgenden Schritte:
Bilden einer zweiten metallisierten Bindungsschicht auf einer zweiten Oberfläche der nichtmetallischen Abstandshalterkomponente (34) gegenüber der ersten Oberfläche, wobei die erste metallisierte Bindungsschicht von der zweiten metallisierten Bindungsschicht getrennt ist;
Positionieren der zweiten Oberfläche der nichtmetallischen Abstandshalterkomponente (34), um sie mit einer metallischen Oberfläche der ersten Komponente (30) zusammenzupassen, wobei die erste Komponente (30) entweder eine metallische oder eine nichtmetallische Komponente mit einer metallisierten Bindungsschicht auf der ersten Komponente (30) ist, und Verbinden der zweiten metallisierten Bindungsschicht mit der zusammenpassten metallischen Oberfläche der ersten Komponente (30); und
Positionieren der ersten Oberfläche der nichtmetallischen Abstandshalterkomponente (34), um sie mit einer metallischen Oberfläche einer zweiten Komponente (38) zusammenzupassen, wobei die zweite Komponente (38) entweder eine metallische Komponente (38) oder eine nichtmetallische Komponente (38) mit einer metallisierten Bindungsschicht auf der zweiten Komponente (38) ist, und Verbinden der ersten metallisierten Bindungsschicht mit der zusammenpassten metallischen Oberfläche der zweiten Komponente (38), wobei das Verbinden der nichtmetallischen Abstandshalterkomponente (34) mit der ersten Komponente (30) und mit der zweiten Komponente (38) Metall-zu-Metall-Verbindungstechniken verwendet.

2. Verfahren nach Anspruch 1, wobei die nichtmetallische Abstandshalterkomponente (34) eine ist aus einer Gruppe bestehend aus:
einer polymeren Komponente;
einer keramischen Komponente;
einer Keramik-Polymer-Verbundkomponente; und
einer Kunstharz-Spritzgusskomponente.

3. Verfahren nach Anspruch 1 oder Anspruch 2, wobei das Verbinden der ersten metallisierten Bindungsschicht mit der zusammengepassten metallischen Oberfläche der zweiten Komponente (38) und das Verbinden der zweiten metallisierten Bindungsschicht mit der zusammengepassten metallischen Oberfläche der ersten Komponente (30) Techniken verwendet, die Kompressionsschmelzschweißen beinhalten.

4. Verfahren nach einem der Ansprüche 1-3, wobei das Bilden einer metallisierten Bindungsschicht zumindest eines der Folgenden beinhaltet:
Galvanisieren;
stromlose Metallabscheidung;
Vakuumabscheidung;
Sputtern eines Metalls, das eines oder mehrere von Ti, Cr, Ta, Ru, NiChrome und NiV beinhaltet; und Dampfabscheidung.

5. Verfahren nach einem der Ansprüche 1-4, ferner umfassend das Modifizieren der Oberfläche der nichtmetallischen Abstandshalterkomponente (34) durch zumindest eines der Folgenden:
eine Ionenquelle, die Sauerstoff oder Argon oder beides enthält, bevor die metallisierte Bindungsschicht auf der Oberfläche der nichtmetallischen Abstandshalterkomponente (34) gebildet wird; und
einer Plasmaquelle, die Sauerstoff oder Argon oder beides enthält, bevor die metallisierte Bindungsschicht auf der Oberfläche der nichtmetallischen Abstandshalterkomponente (34) gebildet wird.

6. Verfahren nach einem der Ansprüche 1-5, wobei die Oberfläche der nichtmetallischen Abstandshalterkomponente (34) eine 3D-Oberfläche ist.

7. Verfahren nach Anspruch 6, ferner umfassend das Bonden oder Aufkleben einer Goldschicht über der metallisierten Bindungsschicht vor dem Verbinden der ersten metallisierten Bindungsschicht mit der zusammengepassten metallischen Oberfläche der zweiten Komponente.

8. Verfahren nach Anspruch 6 oder Anspruch 7, wobei die nichtmetallische Abstandshalterkomponente (34) eine Kunstharz-Spritzgusskomponente ist.

9. Verfahren nach einem der Ansprüche 1-8, wobei das Verbinden der ersten metallisierten Bindungsschicht mit der zusammengepassten metallischen Oberfläche der zweiten Komponente (38) und das Verbinden der zweiten metallisierten Bindungsschicht mit der zusammengepassten metallischen Oberfläche der ersten Komponente (30) Techniken verwendet, die zumindest eines der Folgenden beinhalten:
Wiederaufschmelzen von Lot, das an beiden Oberflächen angebracht ist, und
Wiederaufschmelzen von Lot, das an der metallisierten Bindungsschicht angebracht ist.

10. Verfahren nach Anspruch 9, wobei das Lot mit der nichtmetallischen Abstandskomponente (34) mit einem lötbaren Metall verbunden ist, das eines oder mehrere von Cu, Au, Ag, Ni, Ru, Cd, Sn, Rd, Messing und Pb beinhaltet.

11. Verfahren nach einem der Ansprüche 9-10, wobei das lötbare Metall durch die metallisierte Bindungsschicht kohäsiv an der nichtmetallischen Abstandshalterkomponente (34) verbunden ist.

12. Verfahren nach einem der Ansprüche 9-11, wobei das lötbare Metall ein Intermetall bildet, ohne sich vollständig in das Lot aufzulösen.

13. Verfahren nach einem der Ansprüche 1-12, wobei die zweite Komponente (38) eine Metallkomponente ist.

14. Verfahren nach einem der Ansprüche 1-12, wobei die zweite Komponente (38) eine zweite nichtmetallische Komponente ist, wobei die zusammengepasste metallische Oberfläche der zweiten Komponente (38) eine zweite metallisierte Bindungsschicht beinhaltet.

15. Verfahren nach Anspruch 14, wobei die zweite nichtmetallische Komponente (38) eine ist aus einer Gruppe bestehend aus:
einer polymeren Komponente;
einer keramischen Komponente;
einer Keramik-Polymer-Verbundkomponente; und
einer Kunstharz-Spritzgusskomponente.

## Revendications

1. Un procédé de fabrication comprenant :
la formation d'une première couche de liaison métallisée sur une première surface d'un composant espaceur non métallique (34), le composant espaceur non métallique (34) étant configuré pour assembler un premier composant (30) et un deuxième composant (38) ;
et étant **caractérisés par** les étapes suivantes :
la formation d'une deuxième couche de liaison métallisée sur une deuxième surface du composant espaceur non métallique (34) opposée à la première surface, dans lequel la première couche de liaison métallisée est séparée de la deuxième couche de liaison métallisée ;
le positionnement de la deuxième surface du composant espaceur non métallique (34) pour s'accoupler avec une surface métallique du premier composant (30), le premier composant (30) est un composant métallique ou non métallique avec une couche de liaison métallisée sur le premier composant (30), et l'assemblage de la deuxième couche de liaison métallisée avec la surface métallique accouplée du premier composant (30) ; et
le positionnement de la première surface du composant espaceur non métallique (34) pour s'accoupler avec une surface métallique d'un deuxième composant (38), le deuxième composant (38) est un composant métallique (38) ou un composant non métallique (38) avec une couche de liaison métallisée sur le deuxième composant (38), et l'assemblage de la première couche de liaison métallisée avec la surface métallique accouplée du deuxième composant (38), dans lequel l'assemblage du composant espaceur non métallique (34) avec le premier composant (30) et avec le deuxième composant (38) utilise des techniques d'assemblage métal sur métal.

2. Le procédé selon la revendication 1, dans lequel le composant espaceur non métallique (34) est l'un parmi un groupe constitué de :
un composant polymère ;
un composant céramique ;
un composant composite céramique-polymère ; et
un composant en résine plastique moulé par injection.

3. Le procédé selon la revendication 1 ou la revendication 2, dans lequel l'assemblage de la première couche de liaison métallisée avec la surface métallique accouplée du deuxième composant (38) et l'assemblage de la deuxième couche de liaison métallisée avec la surface métallique accouplée du premier composant (30) utilise des techniques incluant le soudage par fusion et compression.

4. Le procédé selon l'une quelconque des revendications 1 à 3, dans lequel la formation d'une couche de liaison métallisée inclut au moins l'un parmi :
l'électrodéposition ;
le dépôt autocatalytique ;
le dépôt sous vide ;
de pulvérisation cathodique d'un métal incluant un ou
plusieurs parmi Ti, Cr, Ta, Ru, NiChrome et NiV ; et le dépôt en phase vapeur.

5. Le procédé selon l'une quelconque des revendications 1 à 4, comprenant en outre la modification de la surface du composant d'espacement non métallique (34) par au moins un parmi :
une source d'ions contenant de l'oxygène, ou de l'argon ou les deux avant la formation de la couche de liaison métallisée sur la surface du composant espaceur non métallique (34) ; et
une source de plasma contenant de l'oxygène, ou de l'argon ou les deux avant la formation de la couche de liaison métallisée sur la surface du composant espaceur non métallique (34).

6. Le procédé selon l'une quelconque des revendications 1 à 5, dans lequel la surface du composant espaceur non métallique (34) est une surface 3D.

7. Le procédé selon la revendication 6, comprenant en outre le collage ou l'adhésion d'une couche d'or sur la couche de liaison métallisée avant d'assembler la première couche de liaison métallisée avec la surface métallique accouplée du deuxième composant.

8. Le procédé selon la revendication 6 ou la revendication 7, dans lequel le composant espaceur non métallique (34) est un composant en résine plastique moulé par injection.

9. Le procédé selon l'une quelconque des revendications 1 à 8, dans lequel l'assemblage de la première couche de liaison métallisée avec la surface métallique accouplée du deuxième composant (38) et l'assemblage de la deuxième couche de liaison métallisée avec la surface métallique accouplée du premier composant (30) utilise des techniques incluant l'une parmi :
la refusion de la soudure fixée aux deux surfaces, et
la refusion de la soudure fixée à la couche de liaison métallisée.

10. Le procédé selon la revendication 9, dans lequel la soudure est collée au composant espaceur non métallique (34) avec un métal soudable incluant un ou plusieurs parmi Cu, Au, Ag, Ni, Ru, Cd, Sn, Rd, laiton et Pb.

11. Le procédé selon l'une quelconque des revendications 9 à 10, dans lequel le métal soudable est collé par cohésion au composant espaceur non métallique (34) par la couche de liaison métallisée.

12. Le procédé selon l'une quelconque des revendications 9 à 11, dans lequel le métal soudable forme un intermétallique sans se dissoudre complètement dans la soudure.

13. Le procédé selon l'une quelconque des revendications 1 à 12, dans lequel le deuxième composant (38) est un composant métallique.

14. Le procédé selon l'une quelconque des revendications 1 à 12, dans lequel le deuxième composant (38) est un deuxième composant non métallique, dans lequel la surface métallique accouplée du deuxième composant (38) inclut une deuxième couche de liaison métallisée.

15. Le procédé selon la revendication 14, dans lequel le deuxième composant non métallique (38) est l'un parmi un groupe constitué de :
un composant polymère ;
un composant céramique ;
un composant composite céramique-polymère ; et
un composant en résine plastique moulé par injection.
